# EUROPEAN PATENT APPLICATION

(11) **EP 1 693 785 A1**
(43) Date of publication of application: **23.08.2006**
(21) Application number: 04820194.1
(22) Date of filing: 07.12.2004
(51) Int. Cl.: G06K 19/00, D21H 21/42

(54) **TAPE WITH EMBEDDED IC CHIP AND SHEET WITH EMBEDDED IC CHIP**

(30) Priority: 10.12.2003 JP 2003411762; 14.09.2004 JP 2004267161
(71) Applicant: OJI PAPER CO., LTD., Tokyo 104-0061 (JP); FEC Corporation, Kanatawa-shi, Ishikawa 920-0377 (JP); Oji Specialty Paper Co., Ltd., Tokyo 1040061 (JP)
(72) Inventor: AYAKI, Mitsuhiro, Tokyo 1040061 (JP); KANDA, Nobuo, Tokyo 1040061 (JP); TOMITA, Keitaro, Tokyo 1040061 (JP); OZAKI, Tuyoshi, Tokyo 1040061 (JP); SUGIMURA, Shiro, Kanazawa-shi, Ishikawa 9200377 (JP); KOBAYASHI, Hideki, Kanazawa-shi, Ishikawa 9200377 (JP)
(74) Representative: Haines, Miles John L.S.
(86) International application number: PCT/JP2004/018188
(87) International publication number: WO 2005/057479

(57) **Abstract**

A sheet with a built-in IC chip in which mechanical external forces do not significantly impinge on the IC chip and the IC chip does not separate or become damaged, and a tape with a built-in IC chip used for the sheet with a built-in IC chip. In the tape with a built-in IC chip, a part or all of the IC chip is embedded in a tape body.

## Description

### Technical Field

The present invention relates to a tape with a built-in IC chip used for a sheet with a built-in IC chip and to a sheet with a built-in IC chip using the tape with a built-in IC chip.

The present invention is based on patent applications in Japan (Japanese Patent Application No. 2003-411762 filed on Dec. 10, 2003 and Japanese Patent Application No. 2004-267161 filed on Sep. 14, 2004), the contents of which is incorporated herein by reference.

### Background Art

Recently, counterfeiting of paper money, etc., has become a serious social problem in association with the progress in copy machine technology. Accordingly, in order to prevent alteration or counterfeiting of paper currency, merchandise coupons, bank checks, stock certificates, passports, IDs, credit cards, etc., various countermeasures for preventing counterfeiting have been taken.

As one such countermeasure, paper for preventing counterfeiting, so-called "thread containing paper", in which a filament-like material (tape) called a "thread" is included between paper layers has been developed as described in patent documents 1 to 4 below. Since the thread containing paper requires high-level technology for including a thread in a paper, it is appropriate as a fabrication-preventing means and has been used for paper currency, merchandise coupons, etc., in many countries.

Also, in order to further improve the fabrication-preventing effects of the thread-containing paper, patent document 5 describes a technique for forming watermarks and for printing micro-characters or micro-images on a thread surface using a metal vapor deposition method.

Recently, a method in which an IC chip is adhered on one surface of a thread of a thin film and the thread is inserted into a sheet-like material, such as paper and plastic, has been proposed, as described in patent document 6, in order to further improve the fabrication-preventing effect.
Patent document 1: Japanese Unexamined Patent Application, First Publication No. Sho 48-75808;
Patent document 2: Japanese Unexamined Patent Application, First Publication No. Sho 50-88377;
Patent document 3: Japanese Unexamined Patent Application, First Publication No. Sho 51-130308;
Patent document 4: Japanese Unexamined Patent Application, First Publication No. Hei 10-292297;
Patent document 5: Japanese Unexamined Patent Application, First Publication No. Hei 10-219597;
Patent document 6: Japanese Unexamined Patent Application, First Publication No. 2002-319006.

### Disclosure of the Invention

### Problems to be Solved by the Invention

The fabrication-preventing paper provided with a thread to which an IC chip is adhered has a better fabrication-preventing effect as compared with those provided with only a thread and no IC chip, as described in patent document 6. However, the thread with an IC chip may cause the following problems due to its structure:
(1) The IC chip is easily separated from the surface by applied external force since the portion to which an IC chip is adhered protrudes from the surface of the thread. In particular, it is likely that an IC chip may become separated and detached from a thread when a mechanical external force or heat is applied thereto during machine processes (a wiring, pressing, drying, and calendering process, etc.). Since it is not easy to detect such detachment caused during a machine process, a number printing process must be carried out to give a distinct number to each if detachment of an IC chip is confirmed after the paper is produced and printed as a fabrication-preventing paper. Also, there is a danger that IC chips may be detached during circulation or use;
(2) Since the portion to which the IC chip is adhered protrudes from the thread, the IC chip itself, and the circuit and function thereof may be damaged by external force applied by, for example, a calender. It may be considered to form a groove at a portion where the thread is inserted so as to decrease the external force applied to the IC chip. However, in this case also, a protruding portion is generated since the thickness of the portion to which an IC chip is adhered becomes thicker than that of a film. Therefore, there is a limit to avoiding the concentration of external force on an IC chip;
(3) Since the thickness of the tape and the IC chip portion is about 25 to 100 µm, the thickness of a portion at which the tape is inserted increases and causes problems, such as (i) tearing of the sheet along the tape or the sides of the chip, (ii) generation of wrinkle, and (iii) elimination of gloss; and
(4) Some printing methods cannot be suitably applied because of the roughness of a surface caused at the insertion portion.

Accordingly, an object of the present invention includes to provide a sheet with a built-in IC chip in which a mechanical external force tends not to be applied to the IC chip and the IC chip is not separated or damaged, and to provide a tape with a built-in IC chip used for the sheet with a built-in IC chip. Other objects of the present invention will be apparent from the detailed description which follows and from the accompanying drawings. Means for Solving the Problem

In order to achieve the above-mentioned object, the present invention includes the following aspects:
(1) A tape with a built-in IC chip used for a sheet with a built-in IC chip, including: a tape body; and an IC chip provided with the tape body, wherein a part or all of the IC chip is embedded in the tape body;
(2) A tape with a built-in IC chip according to (1), wherein all of the IC chip is embedded in the tape body;
(3) A tape with a built-in IC chip according to (2), wherein all of the IC chip is embedded in the tape body in a non-exposed state.
(4) A tape with a built-in IC chip according to any one of (1)-(3), wherein the IC chip is fixed to the tape body by a resin.
(5) A tape with a built-in IC chip according to any one of (1)-(4), wherein the tape body is formed by at least two layers of base materials.
(6) A sheet with a built-in IC chip, including: a sheet-like material; and a tape with a built-in IC chip according to any one of (1)-(5) which is inserted into the sheet-like material.
(7) A sheet with a built-in IC chip according to (6), wherein the tape with a built-in IC chip is embedded in the sheet-like material formed of multilayer paper.
(8) A sheet with a built-in IC chip according to (7), wherein at least a portion of a middle layer of the multilayer paper which corresponds to a position for embedding the IC chip is formed without attaching a sheet raw material to the portion or discontinuously attaching the sheet raw material.
(9) A sheet with a built-in IC chip according to (6), wherein a part of the tape with the built-in IC chip is in an exposed state.
(10) A sheet with a built-in IC chip, including: a sheet-like material; and a tape with the built-in IC chip according to any one of (1)-(5) which is attached to the sheet-like material.

### Effects of the Invention

According to the present invention described in (1) to (5) above, a mechanical external force is not concentratedly applied to the IC chip since a part or the entirety of the IC chip is embedded in a tape body. Therefore, a sheet with a built-in IC chip in which the IC chip is not separated or damaged is obtained according to the present invention.

According to the present invention described in (6) to (10) above, a sheet with a built-in IC chip in which the IC chip is not detached or damaged is obtained. Accordingly, when used as a fabrication-preventing paper, it is not necessary to carry out a number printing process to give a distinct number to each since the IC chip will not be detached. Also, when at least a portion of a middle layer of the multilayer paper which corresponds to a position for embedding the IC chip is formed without attaching a sheet raw material to the portion or discontinuously attaching the sheet raw material, it becomes possible to: (i) eliminate the difference in thickness of a portion at which the tape or the chip is inserted so that paper having no tearing of the sheet along the tape or the sides of the chip, no generation of wrinkle and no lowering in gloss may be obtained; (ii) prevent IC chip from being damaged by applied external force; and (iii) perform a printing process using all kinds of printing methods.

### Brief Description of Drawings

FIG. 1 is a schematic diagram showing a plan view of a tape with a built-in IC chips according to a first embodiment of the present invention;
FIG. 2 is a schematic diagram showing a cross-sectional view of the tape with built-in IC chips according to the first embodiment of the present invention;
FIG. 3 is a schematic diagram showing a plan view of the tape with built-in IC chips according to a second embodiment of the present invention;
FIG. 4 is a schematic diagram showing a cross-sectional view of the tape with built-in IC chips according to the second embodiment of the present invention;
FIG. 5 is a schematic diagram showing a plan view of the tape with built-in IC chips according to a third embodiment of the present invention;
FIG 6 is a schematic diagram showing a cross-sectional view of the tape with built-in IC chips according to the third embodiment of the present invention;
FIG. 7 is a schematic diagram showing a plan view of a sheet with built-in IC chips according to a first embodiment of the present invention;
FIG. 8 is a schematic diagram showing a cross-sectional view of the sheet with built-in IC chips according to the first embodiment of the present invention;
FIG. 9 is a schematic diagram showing a plan view of a sheet with built-in IC chips according to a modification of the first embodiment of the present invention;
FIG. 10 is a schematic diagram showing a cross-sectional view of the sheet with built-in IC chips according to the modification of the first embodiment of the present invention;
FIG. 11 is a schematic diagram showing a plan view of a sheet with built-in IC chips according to another modification of the first embodiment of the present invention;
FIG. 12 is a schematic diagram showing a cross-sectional view of the sheet with built-in IC chips according to the another modification of the first embodiment of the present invention;
FIG. 13 is a schematic diagram showing a plan view of the sheet with built-in IC chips according to a second embodiment of the present invention;
FIG. 14 is a schematic diagram showing a cross-sectional view of the sheet with built-in IC chips according to the second embodiment of the present invention;
FIG. 15 is a schematic diagram showing a third embodiment of the sheet with built-in IC chips according to the present invention; and
FIG. 16 is a schematic diagram showing a fourth embodiment of the sheet with built-in IC chips according to the present invention.

### Description of the Reference Symbols

1: tape with built-in IC chip; 2: sheet-like material; 3: watermark; 10: IC chip; 20: tape body; 21: first base material; 22: second base material; 23: third base material; 30: resin.

### Best Mode for Carrying Out the Invention

Hereinafter, the present invention will be described in detail with accompanying drawings. Note that the dimensional ratio of the diagrams is different from the actual ratio for the sake of explanation and particularly enlarged in a thickness direction.

### <Tape with Built-in IC Chips>

### (First embodiment of the tape with built-in IC chips)

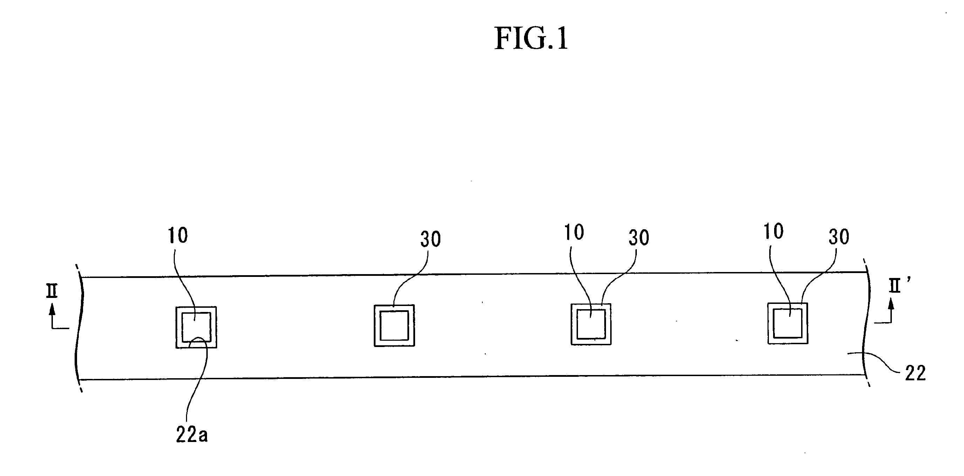

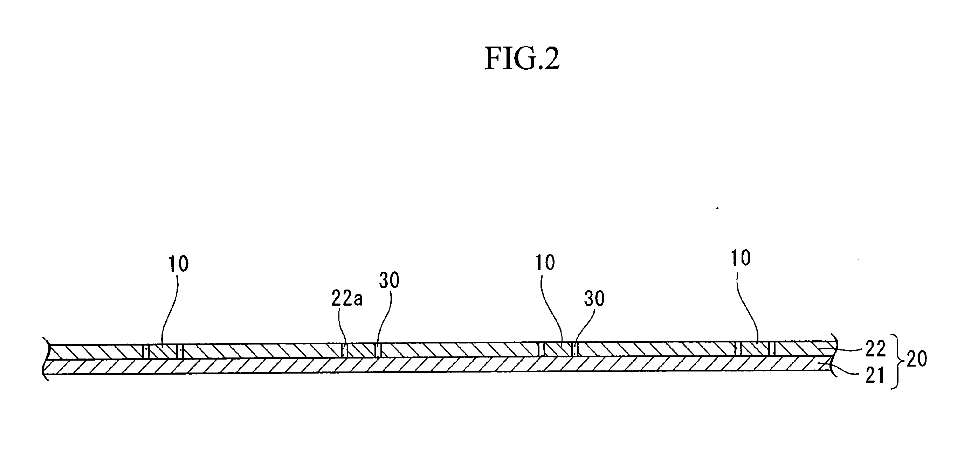

FIGS. 1 and 2 are schematic diagrams showing a first embodiment of a tape with built-in IC chips according to the present invention. FIG. 1 shows a plane view and FIG. 2 shows a cross-sectional view of the tape with built-in IC chips according to the first embodiment.

As shown in FIGS. 1 and 2, the tape with built-in IC chips of this embodiment includes a plurality of IC chips 10, a tape body 20, and a resin 30, and each of the IC chips 10 is embedded in the tape body 20 via the resin 30.

Although the width of the tape body 20 is not particularly limited, it is preferably within the range of 1 to 5 mm. Also, although it is preferable that the length of the tape body 20 be as long as possible, it may be within the range of 500 to 20,000 meters.

The tape body 20 includes a first base material 21 and a second base material 22. The first base material 21 and the second base material 22 may be integrally formed using the same material or may be formed using different materials which are adhered together. The second base material 22 has a plurality of penetrating openings 22a so that an IC chip 10 may be inserted therein.

The resin 30 may be filled between the peripheral surface(s) of the IC chip 10 and the second base material 22. Also, although not shown in the figures, the resin 30 may be filled between the bottom surface of the IC chip 10 and the first base material 21.

The IC chip 10 includes an IC (integrated circuit) and an antenna incorporated therein. When electric energy is supplied to the IC chip 10, information stored in a memory thereof may be read and/or new information may be written by means of a non-contact recognition system.

It is preferable that the size of the IC chip 10 be as small as possible. However, it may be usable with a side of 5 mm or less, and preferably 2 mm or less. The thickness of the IC chip 10 is suitable if it is thinner than the thickness of a final product of the sheet with built-in IC chips. Accordingly, a fine and thin IC chip having a side of 0.5 mm and thickness of 70 µm, for example, may be suitably utilized.

Also, methods for producing the IC chip 10 are not particularly limited, and those described in the above patent document 6 may be suitably employed.

The antenna of the IC chip 10 is preferably an antenna which forms a resonance circuit with a coil element and a capacitor and obtains microwave energy and signals onchip.

In such a case, since the time constant becomes small by utilizing microwaves, it becomes possible to realize a resonance circuit using a microcircuit by adjusting, for example, the inductance of the coil and the electrostatic capacity of the capacitor to 2 nanohenry and 2 picofarad, respectively. In this manner, it becomes possible to dispose an antenna on a fine IC chip having a side of 0.5 mm or less.

The coil element and the capacitor element which form an antenna are connected in parallel or in series, and are connected to a high frequency receiving circuit.

Materials for forming the first base material 21 and the second base material 22 are not particularly limited, and it is possible to use paper, a plastic film, and so forth. It is preferable to make one of the first and second base materials 21 and 22 using paper and the other using a plastic film since the resulting material will not be stretched when being incorporated into paper as a tape with a built-in IC chip.

According to the present invention, various materials may be used, depending on insulation property, mechanical strength, application, etc., as a base material of a plastic film. Examples thereof include a polyester resin, such as polyethylene terephthalate, polybutylene terephthalate, polyethylene naphthalate, polyethylene terephthalate / isophthalate copolymer, terephthalic acid / cyclohexanedimethanol / ethyleneglycol copolymer, cyclohexanedimethanol / ethyleneglycol copolymer, and a polyethylene terephthalate / polyethylene naphthalate co-extrusion film; a polyamide resin, such as nylon 6, nylon 66, and nylon 610; a polyolefin resin, such as polyethylene, polypropylene, and polymethylpentene; a vinyl resin, such as polyvinyl chloride; an acryl resin, such as polyacrylate, polymethacrylate, and polymethylmethacrylate; an imide resin, such as polyimide, polyamideimide, and polyether imide, an engineering resin, such as polyalylate, polysulfone, polyethersulfone, polyphenylene ether, polyphenylene sulfide (PPS), polyaramid, polyether ketone, polyether nitrile, polyetheretherketone, and polyethersulfite; a styrene resin, such as polycarbonate, polystyrene, high impact polystyrene, AS resin, and ABS resin; and a cellulose film, such as cellophane, cellulose triacetate, cellulose diacetate, and nitrocellulose.

Paper that can be used in the present invention is not particularly limited; however, those which contain metals, etc., which interfere with communication with the IC chip 10 are not appropriate. It is possible to use synthetic paper if necessary.

Since the entire IC chip 10 is embedded in the tape body 20 in the tape with built-in chips of this embodiment, a mechanical force tends not be applied to the IC chip 10. Also, since the resin 30 is filled between the periphery of the IC chip 10 and the second base material 22, the IC chip 10 is strongly adhered to the tape body 20. According to the tape with built-in IC chips of this embodiment, therefore, it becomes possible to obtain a sheet with built-in IC chips in which the IC chip 10 will not be separated or damaged.

Also, the thickness of the second base material 22 is equal to that of the IC chip 10 in this embodiment.

In this manner, it becomes possible to embed the entire IC chip 10 into the tape body 20 without uselessly increasing the thickness of the tape body 20.

The tape with built-in IC chip of this embodiment may be produced by the following methods:
(1) A plurality of openings 22a are formed in the second base material 22. Then, the first base material 21 is attached to the bottom surface of the second base material 22. After this, the IC chip 10 to which the resin 30 has been applied to the periphery thereof is inserted into each of the openings 22a from the upper surface side of the second base material 22. Methods for forming the openings 22a in the second base material 22 include one in which the base material 22 is perforated using a metal mold, etc.; and
(2) The tape body 20 in which the first base material 21 and the second base material 22 are integrally formed using the same material is prepared. A plurality of concave portions are formed in the tape body 20 so as to be used as the openings 22a. The IC chip 10 to which the resin 30 has been applied to the periphery thereof is inserted into each of the concave portions (the openings 22a). Methods for forming the concave portions include an injection molding method, a precision boring method, a pressing method using a convex body, a vacuum molding method, a compression molding method, a vacuum-compression molding method, a plug assisted molding method, and a plastic deformation method using a male-female mold.

### (Second embodiment of the tape with built-in IC chips)

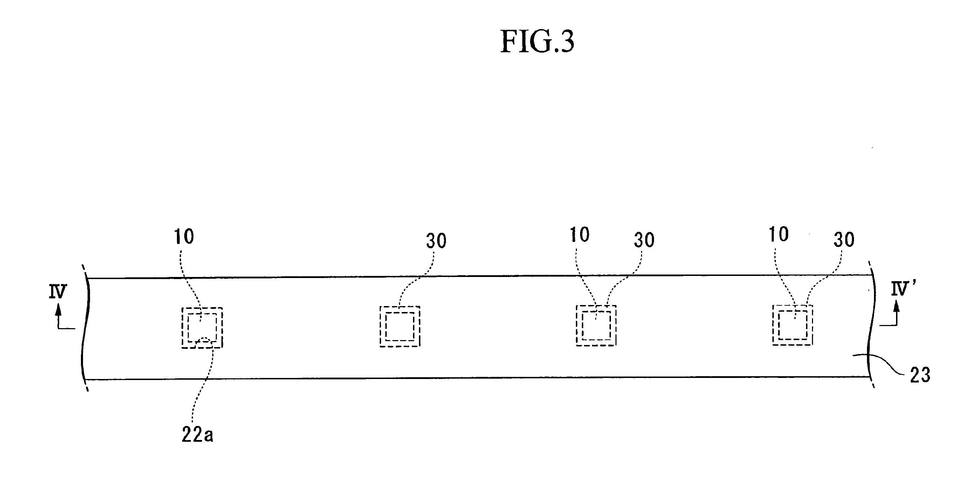

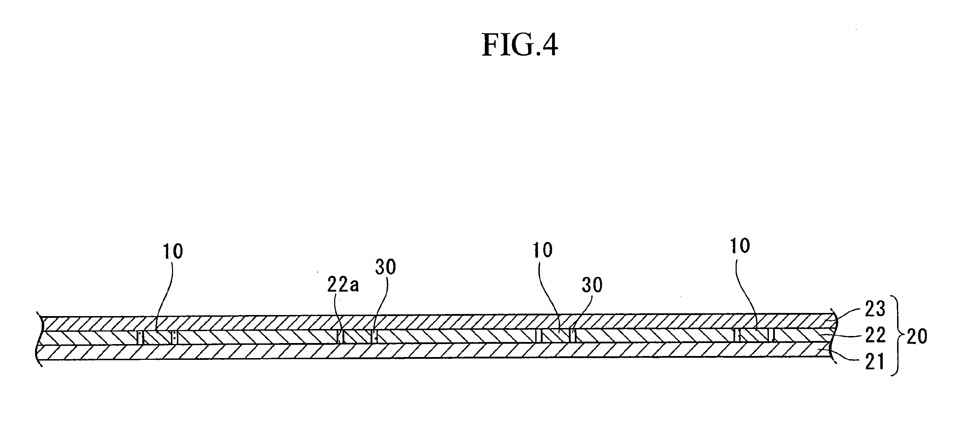

FIGS. 3 and 4 are schematic diagrams showing a second embodiment of the tape with built-in IC chips according to the present invention. FIG. 3 shows a plane view and FIG. 4 shows a cross-sectional view of the tape with built-in IC chips according to the second embodiment of the present invention. Note that structural components shown in FIGS. 3 and 4 which are the same as those shown in FIGS. 1 and 2 are indicated using the same numerals, and the explanation thereof will be omitted.

The tape body 20 in this embodiment includes the first base material 21, the second base material 22 and a third base material 23 which are laminated in this order. As in the first embodiment, the first base material 21 and the second base material 22 may be integrally formed using the same material or may be formed using different materials which are adhered together.

The second base material 22 has a plurality of penetrated openings 22a so that an IC chip 10 may be inserted in each of the openings 22a. The lower side of the opening 22a is covered by the first base material 21, and the upper side of the opening 22a is covered by the third base material 23. That is, the IC chip 10 is embedded in the tape body in a non-exposed state by being sandwiched by the first base material 21 and the third base material 23.

The resin 30 is filled between the periphery of the IC chip 10 and the second base material 22. Note that, although it is not shown in the figures, the resin 30 may be filled between the bottom surface of the IC chip 10 and the first base material 21 and between the upper surface of the IC chip 10 and the third base material 23, if necessary.

The tape with built-in IC chips according to this embodiment may be obtained by adhering the third base material 23 onto the upper side of the tape with built-in IC chips of the first embodiment.

### (Third embodiment of the tape with built-in IC chips)

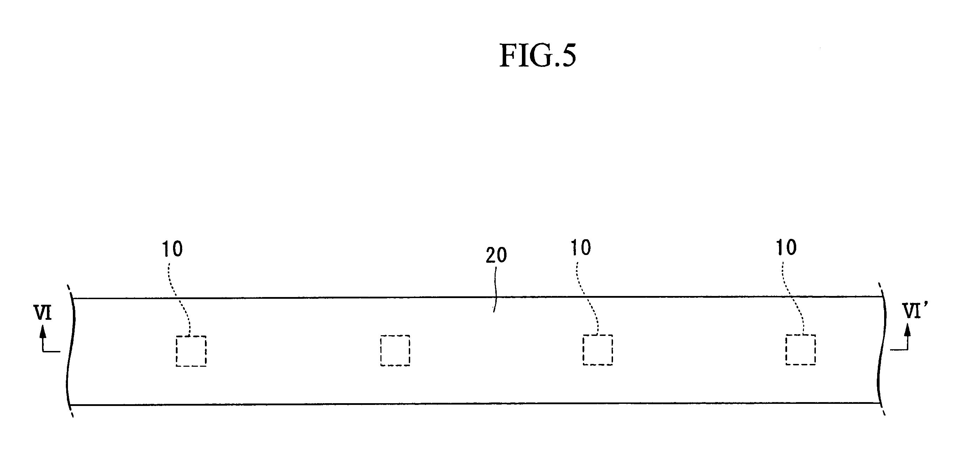

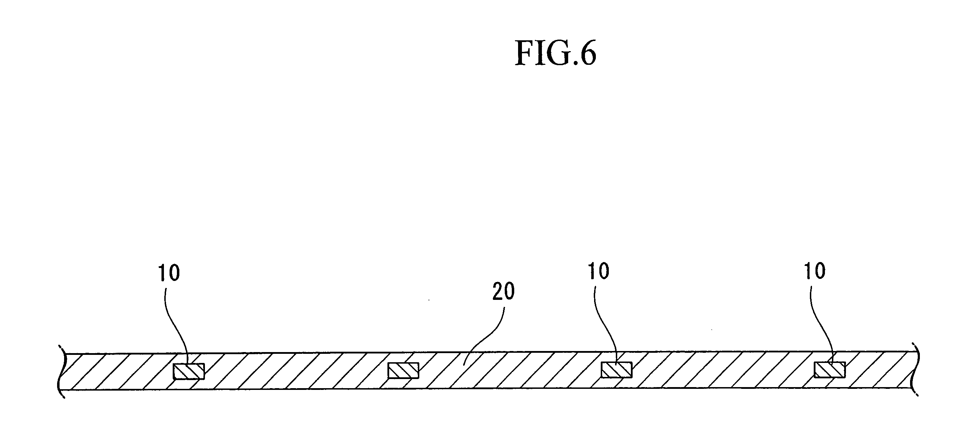

FIGS. 5 and 6 are schematic diagrams showing a third embodiment of the tape with built-in IC chips according to the present invention. FIG 5 shows a plane view and FIG 6 shows a cross-sectional view of the tape with built-in IC chips according to the third embodiment of the present invention. Note that structural components shown in FIGS. 5 and 6 which are the same as those shown in FIGS. 1 and 2 are indicated using the same numerals, and the explanation thereof will be omitted.

In the third embodiment of the present invention, the resin 30 does not form a layer, and each of the IC chips 10 is directly embedded in the tape body 20 in a non-exposed state.

Examples of methods for producing the tape with built-in IC chips of this embodiment include one in which a plurality of IC chips 10 are fixed to a water soluble film of polyvinyl alcohol, etc., and this is incorporated between two layers of paper. According to this method, the water soluble film is dissolved during a machining process and does not form a layer. The dissolved water soluble film contributes to the adhesion between the IC chip 10 and the tape body 20.

### (Other embodiments of the tape with built-in IC chips)

Although plural IC chips 10 are used in each of the embodiments described above, it is possible for only one IC chip 10 to be contained in the tape with built-in IC chips. Also, although the resin 30 is used in the first and second embodiments of the present invention, the resin 30 may be unnecessary if it is possible to prevent the separation of the IC chip 10 by using other means such as the third base material 23 in the second embodiment.

### <Sheet with Built-in IC Chip>

### (First embodiment of the sheet with built-in IC chips)

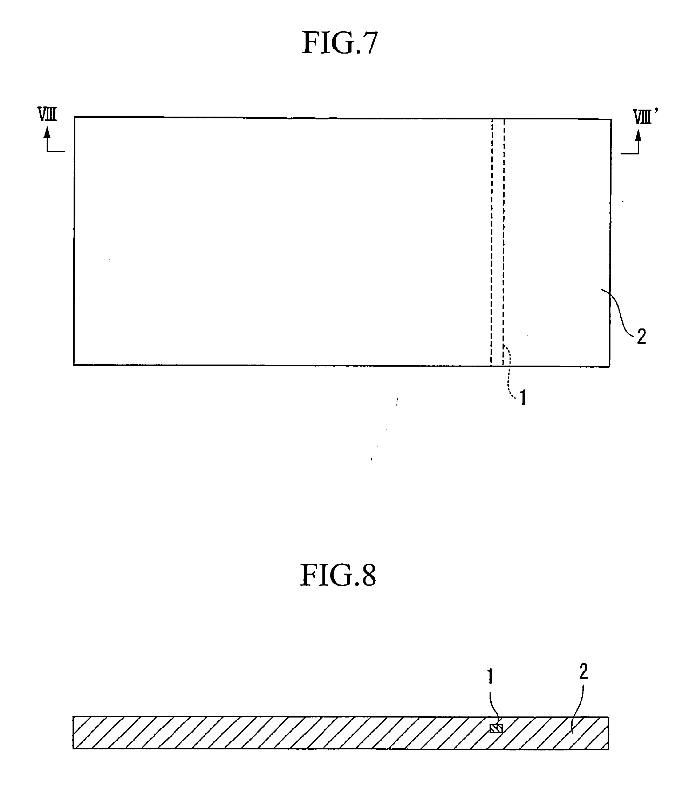

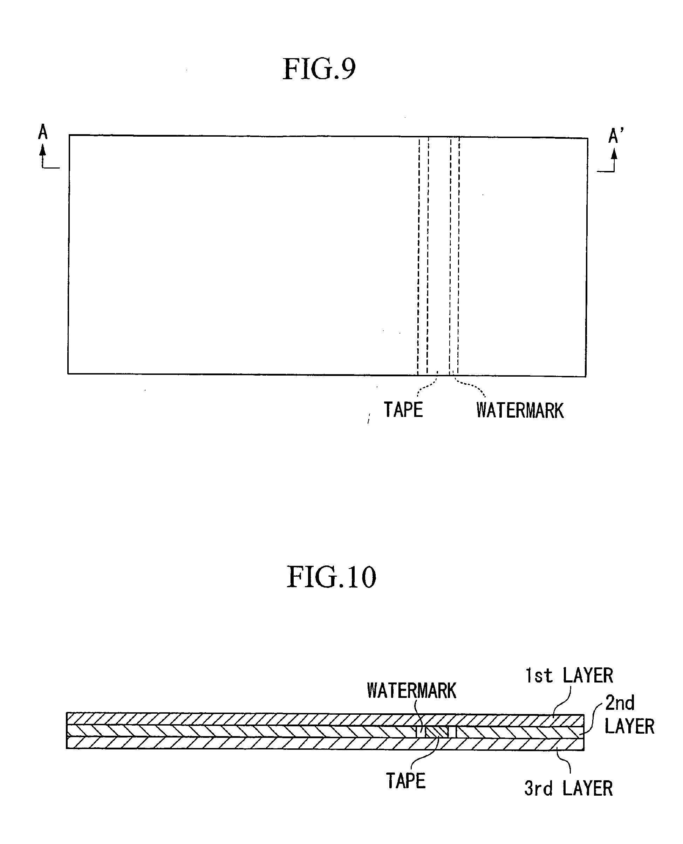

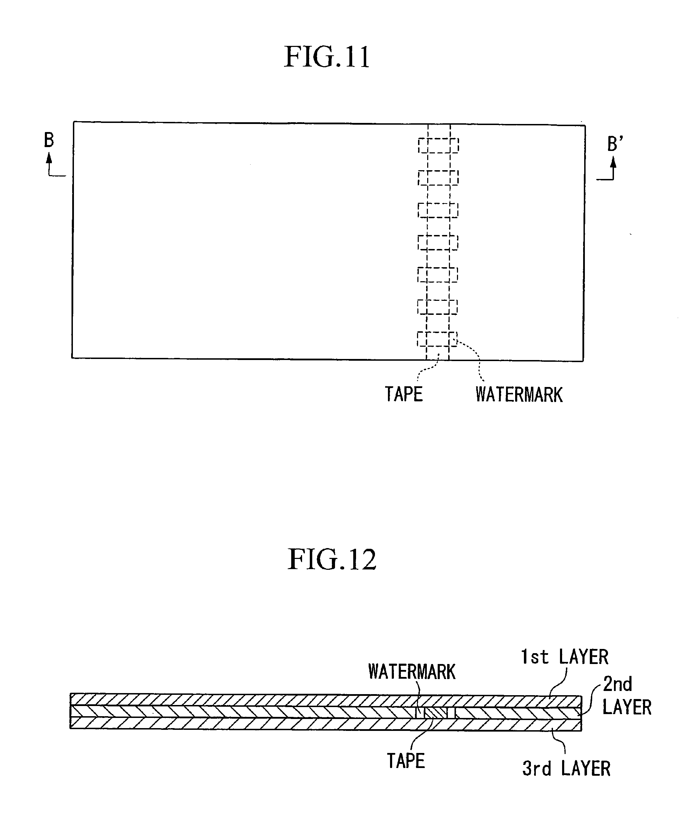

FIGS. 7 and 8 are schematic diagrams showing a first embodiment of a sheet with built-in IC chips according to the present invention. FIG 7 shows a plane view of the sheet with built-in IC chips of the first embodiment and FIG. 8 shows a cross-sectional view of the sheet with built-in IC chips cut along a line VIII-VIII' shown in FIG 7. Also, FIG. 9 shows a plane view of the sheet with built-in IC chips of a modification of the first embodiment and FIG. 10 shows a cross-sectional view of the sheet with built-in IC chips cut along a line A-A' shown in FIG. 9. Likewise, FIG 11 shows a plane view of the sheet with built-in IC chips of another modification of the first embodiment and FIG 12 shows a cross-sectional view of the sheet with built-in IC chips cut along a line B-B' shown in FIG 11.

As shown in FIGS. 7 and 8, the sheet with built-in IC chips of this embodiment includes the tape with built-in IC chip 1 of the present invention and a sheet-like material 2, and the tape with built-in IC chip 1 is inserted into the sheet-like material 2.

Materials for forming the sheet-like material 2 are not particularly limited, and it is possible to use paper, a plastic film, and so forth. It is preferable to use paper since the tape with built-in IC chip 1 may be inserted during a machine process.

Examples of methods for producing the sheet with built-in IC chips according to the present invention include a single-layer paper making method, a multi-layer paper making method, and one in which plural base material sheets are attached together.

Examples of the single-layer paper making method include one in which the tape with built-in IC chip 1 is supplied together with a paper raw material, which is sliced by a long-net paper machine and is transferred to a paper machine wire, so that the tape with built-in IC chip 1 is embedded in the paper layers formed on the paper machine wire as disclosed in Japanese Unexamined Patent Application, First Publication No. Sho 51-13039, and a method in which a device for inserting the tape with built-in IC chip 1 into a paper raw material, which is transferred from a flowbox of a long-net paper machine, is installed and the tape with built-in IC chip 10 is inserted while maintaining a non-contact state of the tape with built-in IC chip 1 and the paper raw material using air-flow as disclosed in Japanese Unexamined Patent Application, First Publication No. Hei 2-169790.

Examples of the multi-layer paper making method include one in which combination paper having at least two layers, namely, an outermost paper layer and an innermost paper layer, is formed using a multi-tank net paper machine and the tape with built-in IC chip 1 is inserted between the paper layers so as to be incorporated therein just before each of the paper layers are superimposed to be adhered.

In this manufacturing method, at least a portion of a middle layer which corresponds to a position for embedding the IC chip may be formed without attaching a sheet raw material to the portion or discontinuously attaching the sheet raw material.

More specifically, in this manufacturing method, the sheet raw material may not be attached to a portion of the middle layer, the width of which corresponds to the width of the tape to be embedded. In practice, however, the width of the portion is not necessarily the same as that of the tape to be embedded, and may be wider than the width of the tape as long as it does not cause roughness of the surface of the sheet. It is preferable that the width of the portion is somewhat wider than that of the tape to be embedded so that the tape may be meandering in some degree when being embedded.

Furthermore, the sheet raw material may be discontinuously attached and, for example, the sheet raw material may be attached with an interval of a few millimeter.

When the single-layer or multi-layer paper making method is employed, there is a danger that the tape with built-in IC chips may be separated from the paper layers by being pulled off, etc., if the tape with built-in IC chip 1 is not strongly adhered to the paper layers. In order to solve this problem, it may be considered to use a water soluble resin in a size press solution in a paper machine process and to apply a thermoplastic resin or a water soluble resin to the tape with built-in IC chip 1 in advance so as to increase the bonding strength between the paper layers and the tape with built-in IC chip 1. In addition, the bonding strength between the paper layers and the tape with built-in IC chip 1 may be increased by using a film and paper as the base material for the tape with built-in IC chip 1.

Next, the method for inserting the tape with built-in IC chip 1 between paper layers by attaching plural base material sheets will be explained. In this case, materials used for the base material sheet are not particularly limited, and it is possible to use, other than paper, a plastic film and so forth.

Examples of resins used for the attachment include a water soluble resin, a heat melting resin made of a thermoplastic polymer, and a heat curing resin. Among them, a curing type resin is preferable since a bonding formed by the resin is hardly broken after once being bonded.

From the viewpoints of the adhesive strength and the ease of handling, an ethylenic resin, a styrene resin, a vinyl chloride resin, a vinylidene chloride resin, an ethylene / vinyl acetate copolymer resin, butyral resin, a polyester resin, a polyamide resin, an acryl resin, a nitrile resin, a butadiene resin, a halogenated rubber, an urethane resin, a cellulose resin, gelatin, a phenol resin, a urea • formaldehyde resin, a melamine • formaldehyde resin, an epoxy resin, an unsaturated polyester resin, a silicon resin, an alkyd resin, an allyl resin, a furan resin, copolymer of monomers which form the above-mentioned resins and so forth may be suitably used according to the present invention.

Among them, a polyester resin, low density polyethylene, atactic polypropylene, ethylene-vinyl acetate copolymer, ethylene-acrylic acid copolymer, ethylene-ethylacrylate copolymer, vinyl acetate-crotonic acid copolymer, vinyl acetate-phthalic anhydride copolymer, styrene-isoprene-styrene block copolymer, styrene-butadiene-styrene block copolymer, styrene-ethylene-butylene-styrene block copolymer, nylon-12, terephthalic acid-1,3-butadiol copolymer may be suitably used according to the present invention. The heat melting resin including the thermoplastic polymer may be used singularly or in a mixture of two or more. Also, it is possible to include a curing agent therein.

Examples of the adhering methods include: (a) one in which the tape with built-in IC chip 1 is placed on a surface of one of the base material sheets, a resin is applied on a surface of the other base material sheet, and these base material sheets are adhered; (b) one in which a resin layer is formed on a surface of a base material sheet in advance, and the other base material sheet is superimposed thereon in a state in which the tape with built-in IC chip 1 is disposed; and (c) one in which the tape with built-in IC chip 1 is disposed on a surface of one of the base material sheets, another base material sheet is disposed thereon so that a resin in a film state or in a powdery state is placed between the two base material sheets, and the resin is heated so as to adhere the base material sheets. From the viewpoints of stability in adhesion and operational efficiency, the method described in (b) above is most preferable.

Also, a low-temperature laminating method using a thermal primer treatment may be adopted when the resin in a film state is employed, and an electrostatic coating method, a meshroll spraying method, a thermal spraying method, a spraying method, a screen printing method, and so forth may be adopted when a powdery binding agent is employed.

### (Second embodiment of the sheet with built-in IC chips)

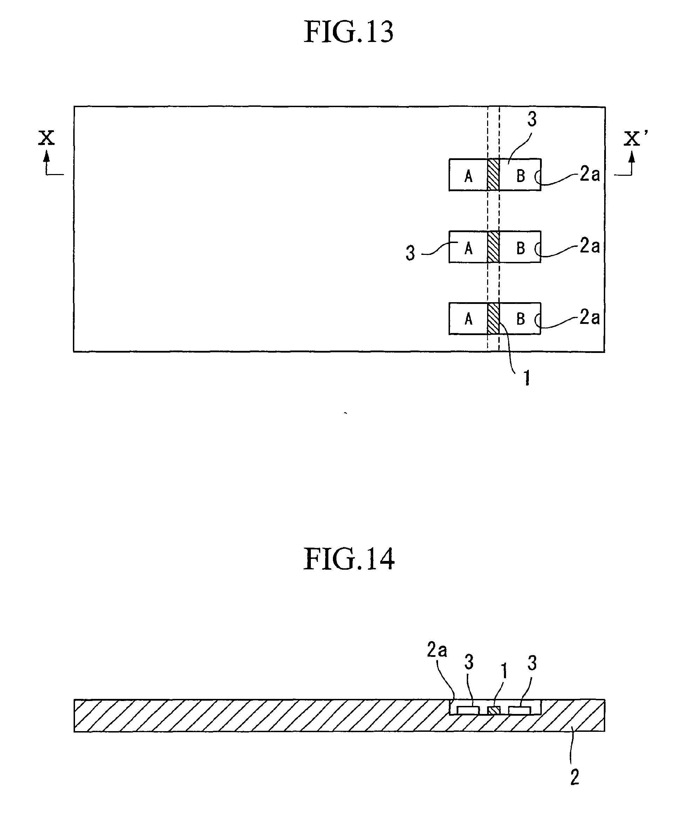

FIGS. 13 and 14 are schematic diagrams showing a second embodiment of a sheet with built-in IC chips according to the present invention. FIG. 13 shows a plane view of the sheet with built-in IC chips of the second embodiment and FIG. 14 shows a cross-sectional view of the sheet with built-in IC chips cut along a line X-X' shown in FIG. 13.

As shown in FIGS. 13 and 14, the sheet with built-in IC chips of this embodiment includes the tape with built-in IC chip 1 according to the present invention and a sheet-like material 2, and the tape with built-in IC chip 1 is inserted into the sheet-like material 2. Note that a part of the tape with built-in IC chip 1 is in an exposed state in a space portion 2a provided with the sheet-like material 2. In this second embodiment, watermarks 3 are further provided with the space portion 2a.

Examples of the methods for producing the sheet with built-in IC chips of this embodiment include: one in which a belt mechanism including a guide having a concave-convex portion, the tip of the convex portion thereof is provided with a groove for accommodating the tape with built-in IC chip 1, is embedded in a suspension of paper raw material on a paper machine net wire as disclosed in Japanese Examined Patent Application, Second Publication, No. Hei 5-085680; one in which a nozzle for compressed air is provided with a revolving drum on a long-net machine wire, and a slurry on the tape with built-in IC chip 1 which has been inserted into a wet paper in advance is intermittently blown using compressed air so as to expose the tape with built-in IC chip 1 as disclosed in Japanese Unexamined Patent Application, First Publication, No. Hei 6-272200; and one in which a net which has been processed so as to be rough is used as an upper net of a net paper machine, and the tape with built-in IC chip 1 is incorporated into a space portion by inserting the tape with built-in IC chip 1 therein while being contacted with the rough surface of the net as disclosed in U.S. Patent No. 4,462,866.

Also, another method may be adopted in which when combination paper including at least two layers, namely, an outermost paper layer and an innermost paper layer, is formed using a multi-tank net paper machine, space portions are intermittently formed in the outermost paper layer (or an inner paper layer), and the tape with built-in IC chip 1 is inserted between paper layers so that (a part of) the tape with built-in IC chip 1 is exposed just before an inner paper layer (or the outermost paper layer) having no space portions is superimposed thereon.

### (Third and fourth embodiments of the sheet with built-in IC chips)

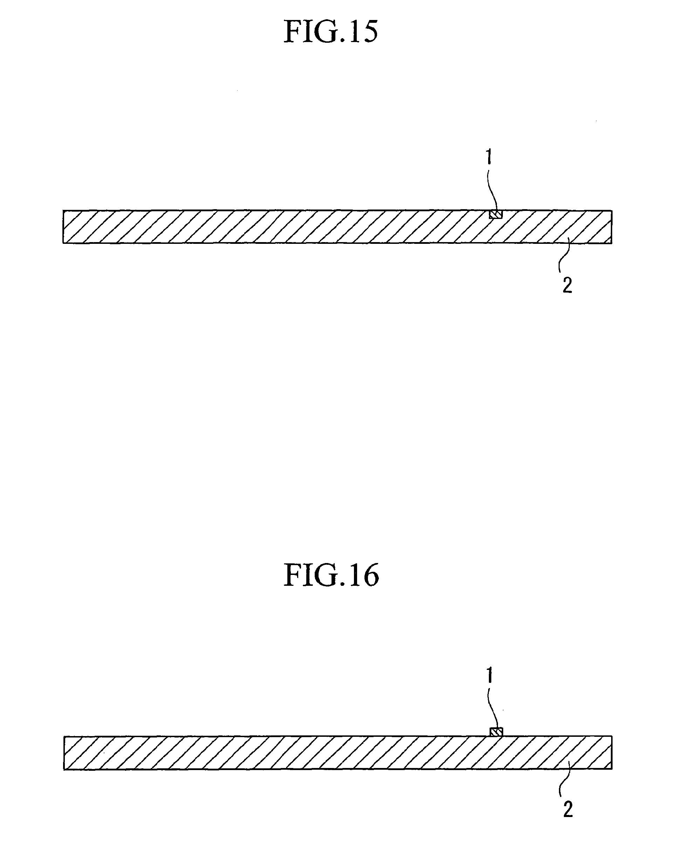

FIGS. 15 and 16 are schematic diagrams showing a third embodiment and a fourth embodiment of the sheet with built-in IC chips according to the present invention.

As shown in FIGS. 15 and 16, each of the sheet with built-in IC chips of these embodiments includes the tape with built-in IC chip 1 according to the present invention and the sheet-like material 2.

In the third embodiment of the present invention shown in FIG. 15, the tape with built-in IC chip 1 is attached to a groove formed on the sheet-like material 2. In the fourth embodiment of the present invention shown in FIG 16, on the other hand, the tape with built-in IC chip 1 is attached to a surface of the sheet-like material 2.

Since the tape with built-in IC chip 1 is protected from a mechanical external force due to the presence of the groove, the third embodiment may be more preferable than the fourth embodiment. Note that the depth of the groove may be suitably altered according to the thickness, materials, etc., of the IC chip, the tape with built-in IC chip 1, and the sheet-like material 2, and is preferably within the range of 0.5 to 2 times of the thickness of the IC chip.

As for the method for producing the sheet with built-in IC chips according to the third embodiment of the present invention, it is effective to reduce the thickness of only paper layers between which the tape with built-in IC chip 1 is inserted and to form a groove for inserting the tape with built-in IC chip 1.

More specifically, it is possible to use known watermarking techniques. Examples of such techniques include a method in which a wire, metal, resin, paper, etc., is soldered or attached using a resin to an upper net of a circular net cylinder, a method in which wove is sealed by applying a paint, resin, etc., onto a net, a method in which a net for papermaking is directly roughened, a method in which a mold is attached to a net using a photosensitive resin, a method in which compressed air is blown, in a wet paper state, to a part so as to form a groove, a method in which a portion is abraded, in a wet paper state, using an abrasion roll so as to form a groove, and so forth.

Hereinafter the present invention will be explained in detail with reference to examples; however, it is apparent that these examples are used for illustration purpose only, and the present invention is not limited to these examples by any means.

### Example 1

### (Preparation of tape with built-in IC chips)

A tape body of 500 m length was produced by slitting a polyethylene terephthalate (PET) film having a thickness of 75 µm to 2.5 mm width. Then, holes of 0.6 × 0.6 mm (length and width) were formed in the obtained PET film by means of a press working using a metal mold. After this, a covering tape ("Denka Thermo Film ALS", a product of Denki Kagaku Kogyo, K.K.) was attached to one of the surfaces (a bottom surface) of the PET film so that the holes became concave portions.

After inserting a fine IC chip having a side of 0.5 mm and a thickness of 70 µm into each of the concave portions from the direction (an upper surface) opposite the surface to which the covering tape of the PET film was attached, the same covering tape was also attached to the surface. In this manner, a tape with built-in IC chips in which the entire structure of the fine IC chips was embedded in the tape body in a non-exposed state was obtained.

### (Preparation of sheet with built-in IC chips 1)

A sheet with built-in IC chips was produced by combining two layers at a rate of 50 m/min using a cylinder paper machine provided with two cylinder vats. At that time, the above-mentioned tape with built-in IC chips was inserted between a first layer (paper having a dry weight of 51 g/m²) and a second layer (paper having a dry weight of 51 g/m²), and the sheet with built-in IC chips was obtained.

### (Preparation of sheet with built-in IC chips 2)

Using a three layer cylinder paper machine which was operated at a combining rate of 50 m/min, a tape with built-in IC chip (having a maximum thickness of 70µm) was inserted between layers to form a sheet with built-in IC chip. That is, the first layer (dry weight of 25 g/m²) and the second layer (dry weight of 55 g/m²) were combined using an ordinary method, and the tape with built-in IC chip was inserted when the third layer (dry weight of 25 g/m²) was combined.

In order to form a portion of 10 mm width which corresponds to the insertion position of the tape, a continuous band-like mark having a 10 mm width was attached around the second layer cylinder so that a raw material was not attached to the portion. In this manner, a sheet with built-in IC chip in which the sheet raw material was not attached to the portion of 10 mm width and which has no roughness on the surface due to the inserted tape was obtained.

### (Preparation of sheet with built-in IC chips 3)

Using a three layer cylinder paper machine which was operated at a combining rate of 50 m/min, a tape with built-in IC chip (having a maximum thickness of 70µm) was inserted between layers to form a sheet with built-in IC chip. That is, the first layer (dry weight of 25 g/m²) and the second layer (dry weight of 55 g/m²) were combined using an ordinary method, and the tape with built-in IC chip was inserted when the third layer (dry weight of 25 g/m²) was combined.

In order to form a plurality of portions of 10 mm width at 2 mm intervals which correspond to the insertion position of the tape, a mark having a 10 mm width was attached around the second layer cylinder with 2 mm intervals so that a raw material was not attached to the portions. In this manner, a sheet with built-in IC chip in which the sheet raw material was not attached to the portions of 10 mm width at 2 mm intervals and which has no roughness on the surface due to the inserted tape was obtained.

### (Preparation of sheet with built-in IC chips 4)

Using a cylinder paper machine provided with a four layer cylinder vat which was operated at a combining rate of 50 m/min, a tape with built-in IC chip was inserted between layers to form a sheet with built-in IC chip. That is, the first layer and the second layer (each having a dry weight of 51 g/m²) were combined using an ordinary method, and the tape with built-in IC chip as in Example 1 was inserted when the third layer (dry weight of 51 g/m²) was combined.

In order to form a portion of 10 mm width which corresponds to the insertion position of the tape, a continuous band-like mark having a 10 mm width was attached around the third layer cylinder so that a raw material was not attached to the portion. For the fourth layer cylinder, a mark was attached to the surface of the cylinder so that a watermark window of 10 × 10 mm was formed with a predetermined interval at a position corresponding to the insertion position of the tape with built-in IC chip. In this manner, a sheet with built-in IC chip in which the sheet raw material was not attached to the portion of 10 mm width so that roughness of the surface was not caused due to the inserted tape, and the tape with built-in IC chip inserted into the paper layers was visible at a predetermined interval through the surface thereof was obtained.

### Example 2

Paper with built-in IC chips was produced by combining three layers at a rate of 50 m/min using a cylinder paper machine provided with three cylinder vats. At that time, a first layer (paper having a dry weight of 51 g/m²) and a second layer (paper having a dry weight of 51 g/m²) were combined using an ordinary method, and the same tape with built-in IC chips as in Example 1 was inserted when a third layer (paper having a dry weight of 51 g/m²) was combined.

A mark was put on the surface of the cylinder for the third layer and the layer was combined so that a watermark window of 10 × 10 mm was formed with a predetermined interval at portions where the tape with built-in IC chips was inserted. In this manner, a sheet in which the tape with built-in IC chips inserted at predetermined interval was visible through the surface was obtained.

### Example 3

An ethylene-vinyl acetate copolymer binder ("Saibinol DBA107", a product of Saiden Chemical Industry, Co., Ltd.) was applied onto paper of 51 g/m² using a roll coater so that a coating amount became 10 g/m². When another paper of 51 g/m² was attached to the binding surface, the tape with built-in IC chips used in Example 1 was inserted between the papers, and a sheet with built-in IC chips was obtained.

### Example 4

### (Preparation of sheet with built-in IC chips)

Three kinds of stuff for a surface layer, a middle layer, and a bottom layer were prepared. That is, for the surface layer, pulp including 30% by weight of N-Bleached Kraft Pulp and 70% by weight of L-Bleached Kraft Pulp, and having Canadian Standard Freeness (CSF) of 400 ml was prepared. For the middle layer, pulp including 20% ofN-Bleached Kraft Pulp, 20% of L-Bleached Kraft Pulp, 20% of woodfree waste paper, and 40% news (old newspaper), and having CSF of 350 ml was prepared. For the bottom layer, pulp including 25% of N-Bleached Kraft Pulp, 25% of L-Bleached Kraft Pulp, and 50% news (old newspaper), and having CSF of 400 ml was prepared. Aluminum sulfate was added to each of pulp slurry so as to adjust the pH thereof to 6.0.

Each of the above pulp slurry was combined using a cylinder three-layer combination machine under a condition of 100 g/m² for the surface layer, 200 g/m² for the middle layer, and 50 g/m² for the bottom layer, and three-layer paper having a thickness of 300 µm was obtained.

The obtained three-layer paper was slit into 2.5 mm width and a tape body having a length of 2,000 m was produced. Then, holes of 0.6 × 0.6 mm (length and width) were formed in the three-layer paper by means of a press working using a metal mold. After this, a bottom covering tape ("Chip Bottom Tape SP type", a product of Nihon Matai Co., Ltd.) was attached to one of the surfaces (a bottom surface) of the three-layer paper so that the holes became concave portions.

After inserting a fine IC chip having a side of 0.5 mm and a thickness of 70 µm into each of the concave portions from the direction (an upper surface) opposite the surface to which the covering tape for the three-layer paper was attached, a top covering tape ("Cover Tape No. 318H-14A", a product ofNitto Denko Corporation) was also attached to the surface. In this manner, a tape with built-in IC chips in which the entire structure of the fine IC chip was embedded in the tape body in a non-exposed state was obtained.

### (Preparation of sheet with built-in IC chips)

An ethylene-vinyl acetate copolymer binder ("Saibinol DBA107", a product of Saiden Chemical Industry, Co., Ltd.) was applied onto paper of 175 g/m² using a roll coater so that a coating amount became 10 g/m². When another paper of 175 g/m² was attached to the binding surface, the above-mentioned tape with built-in IC chips was inserted between the papers, and a sheet with built-in IC chips was obtained.

### Industrial Applicability

As explained above, the tape with built-in IC chip and the sheet with built-in IC chip according to the present invention may be effectively used for paper currency, merchandise coupons, bank checks, stock certificates, passports, IDs, credit cards, physical distribution tags, and so forth.

## Claims

1. A tape with a built-in IC chip used for a sheet with a built-in IC chip, comprising: a tape body; and an IC chip provided with the tape body, wherein a part or all of the IC chip is embedded in the tape body.

2. A tape with a built-in IC chip according to claim 1, wherein all of the IC chip is embedded in the tape body.

3. A tape with a built-in IC chip according to claim 2, wherein all of the IC chip is embedded in the tape body in a non-exposed state.

4. A tape with a built-in IC chip according to any one of claims 1-3, wherein the IC chip is fixed to the tape body by a resin.

5. A tape with a built-in IC chip according to any one of claims 1-4, wherein the tape body is formed by at least two layers of base materials.

6. A sheet with a built-in IC chip, comprising: a sheet-like material; and a tape with a built-in IC chip according to any one of claims 1-5 which is inserted into the sheet-like material.

7. A sheet with a built-in IC chip according to claim 6, wherein the tape with a built-in IC chip is embedded in the sheet-like material formed of multilayer paper.

8. A sheet with a built-in IC chip according to claim 7, wherein at least a portion of a middle layer of the multilayer paper which corresponds to a position for embedding the IC chip is formed without attaching a sheet raw material to the portion or discontinuously attaching the sheet raw material.

9. A sheet with a built-in IC chip according to claim 6, wherein a part of the tape with a built-in IC chip is in an exposed state.

10. A sheet with a built-in IC chip, comprising: a sheet-like material; and a tape with a built-in IC chip according to any one of claims 1-5 which is attached to the sheet-like material.
